# EUROPEAN PATENT APPLICATION

(11) **EP 4 607 795 A1**
(43) Date of publication of application: **27.08.2025**
(21) Application number: 25158852.1
(22) Date of filing: 19.02.2025
(51) Int. Cl.: H03K 17/0412, H02H 3/08, H03K 17/16

(54) **MULTIPURPOSE INTELLIGENT GATE DRIVER FOR SOLID-STATE SWITCHES**

(30) Priority: 22.02.2024 US 202418584368
(71) Applicant: ABB SCHWEIZ AG, 5400 Baden (CH)
(72) Inventor: PATNI, Abhinav, Raleigh, 27606 (US); CHAVAN, Govind S., Garner, 27529 (US); XU, Chunmeng, Raleigh, 27606 (US); DONG, Zhou, Raleigh, 27606 (US)
(74) Representative: Maiwald GmbH

(57) **Abstract**

A multipurpose solid-state switch, including an input for receiving an input signal, a plurality of gate drive circuits, and at least one switch. The plurality of gate drive circuits are each configured with a different combination of passive and/or active electrical components. The at least one switch is arranged between the input and each of the plurality of gate drive circuits. The at least one switch is configured to switch between each of the plurality of gate drive circuits and thereby divert a drive signal to any one of the plurality of gate drive circuits. The switch is configured to switch between the plurality of gate drive circuits based on the input signal received from the input.

## Description

### FIELD

The present disclosure relates to solid-state switches and multipurpose gate drivers as well as systems including the same. The present disclosure also relates to systems and methods for controlling gate driving in solid-state switches.

### BACKGROUND OF THE INVENTION

Gate drivers are known that use a low-power input to produce a high-current drive input for the gate of a high-power transistor. This allows a controller only rated for low-power outputs to control the high-power transistor, which can include, for example, an insulated-gate bipolar transistor (IGBT) or a metal-oxide-semiconductor field-effect transistor (MOSFET). Gate drivers serve an important power amplification role in a variety of electronic devices in varying applications.

By way of example, gate drivers may be used in short-circuit (SC) and/or fault-current-limiting (FCL) applications, such as in a solid-state circuit breaker (SSCB) and solid-state fault current limiters (SSFCL). In an SSCB, gate drivers are implemented based on the highest design priorities or use cases of a particular SSCB. For instance, an SSCB of a particular electrical system may require a variety of design priorities including maximized current limiting bandwidth, minimal turn-off time for SC protection, a precise turn-off time for SC coordination protection, a precise turn-off time for FCL within a specific minimum/maximum current band, a minimized voltage overshoot or FCL within a specific minimum/maximum current band, minimized switching loss and/or a minimized voltage overshoot for a maximal time duration of continuous FCL. Some of these design priorities/use cases are more complex than others. For example, SC coordination protection is a somewhat complex task entailing multiple devices that are configured to "coordinate" with one another to protect a distribution system effectively, despite the devices having unique properties (e.g., turn-off time capability). The foregoing priorities or use cases can each require a separate customized or highly optimized gate driver. Conventional gate drivers are commercially available which are optimized for one design priority. But optimization of gate drive circuitry for a particular design priority results in reduced performance in other design priorities. As an example, a gate driver optimized for minimal turn-off time (a first design priority) will have a higher voltage overshoot than a gate driver optimized for minimal voltage overshoot (a second design priority). This disadvantage of gate drivers cannot be eliminated by control algorithms alone, as the optimizations and corresponding performance tradeoffs of a gate driver are tied to its circuitry. Accordingly, conventional SSCB implementations with multiple design priorities require a plurality of gate drivers individually optimized for each design priority. This can lead to bulky hardware implementations that are inefficient in terms of space and cost and can lead to increased hardware complexity.

### BRIEF SUMMARY OF THE INVENTION

In an embodiment, the present disclosure provides a multipurpose solid-state switch, comprising an input for receiving an input signal, a plurality of gate drive circuits, and at least one switch. The plurality of gate drive circuits are each configured with a different combination of passive and/or active electrical components. The at least one switch is arranged between the input and each of the plurality of gate drive circuits. The at least one switch is configured to switch between each of the plurality of gate drive circuits and thereby divert a drive signal to any one of the plurality of gate drive circuits. The switch is configured to switch between the plurality of gate drive circuits based on the input signal received from the input.

### BRIEF DESCRIPTION OF THE SEVERAL VIEWS OF THE DRAWINGS

Subject matter of the present disclosure will be described in even greater detail below based on the exemplary figures. All features described and/or illustrated herein can be used alone or combined in different combinations. The features and advantages of various implementations will become apparent by reading the following detailed description with reference to the attached drawings, which illustrate the following:
FIG. 1 illustrates a system diagram for a conventional circuit breaker system having multiple design priorities and multiple corresponding gate drivers;
FIG. 2 illustrates a system diagram for a circuit breaker system according to an embodiment of the present disclosure with a unitary gate driver for multiple design priorities;
FIG. 3A illustrates variations in turn-off speed of two gate drive circuits having different design priorities;
FIG. 3B illustrates variations in voltage overshoot of two gate drive circuits having different design priorities;
FIG. 3C illustrates variations in device current of two gate drive circuits having different design priorities.
FIGS. 4A and 4B illustrate circuit diagrams of varying gate drive circuits;
FIGS. 5A and 5B schematically illustrate multipurpose gate driver systems according to embodiments of the present disclosure; and
FIG. 6 is a block diagram of an exemplary processing system, which can be configured to perform any and all operations disclosed herein.

### DETAILED DESCRIPTION OF THE INVENTION

Aspects of the present disclosure include systems and devices for diverting a supply voltage to one of a plurality of gate drive circuits. Each of the plurality of gate drive circuits is configured or optimized for a specific design priority in terms of its optimization. The design priorities are based on short-circuit (SC), fault-current-limiting (FCL), and/or other applications of components of the system. The plurality of gate drive circuits thereby allow the disclosed systems and devices to provide consolidated gate drive circuit selection according to the needs of a particular electrical system into which they are integrated. Aspects of the present disclosure also include methods for selecting one of a plurality of gate drive circuits in order to meet the varying design priorities of a particular electrical system. The terms "design priority" and "use case" may be understood to be used interchangeably throughout the present disclosure.

The disclosed systems, devices, and methods herein improve space and cost efficiency for electrical systems having multiple design priorities, which systems would otherwise require implementation of different entire gate drivers and/or hardware modules in order to satisfy each individual design priority. Aspects of the present disclosure thus reduce system complexity, reduce system part count and inefficient hardware redundancies, and enable intelligent gate drive circuit selection that more closely caters to varying design priorities.

In an embodiment, a multipurpose intelligent gate driver is provided for various SC and FCL applications. The multipurpose intelligent gate driver can be implemented and configured to modify and transmit a drive signal to a high-power component, which can include, for example, an insulated-gate bipolar transistor (IGBT), a metal-oxide-semiconductor field-effect transistor (MOSFET), or an integrated gate-commutated thyristor (IGCT). The multipurpose intelligent gate driver can be implemented in a system together with a solid-state circuit breaker (SSCB) or any other system that involves high device currents (e.g., power converters). The multipurpose intelligent gate driver allows for implementation of multiple use case-specific turn-off circuits on a single gate driver package through intelligent selectivity. Multiple predefined hardware circuits on one gate driver module are provided, with each predefined hardware circuit optimized for a specific SC or FCL protection use-case. Switching between the predefined hardware circuits can be accomplished by an automatic or manual selection. The foregoing features obviate the need to implement multiple gate drivers or gate driver units and even multiple SSCBs to accomplish similar multi-functional circuit design. Moreover, the foregoing features provide increased flexibility of SSCB applications while minimizing spatial footprints, significantly reducing costs, simplifying system design complexity, and increasing both the safety and reliability of SSCBs or like systems. Safety and reliability are increased in response to an increase in optimized gate drive circuit performance, as a gate drive circuit can be selected according to a use case with greater frequency, thereby preventing damage that can result optimization when a sub-optimal gate drive circuit would otherwise be selected. In a specific example, instances of voltage overshoot that may result in hardware damage or reduced safety can be prevented or avoided in use cases where voltage overshoot should be prioritized over turn-off speed. Because the foregoing features increase system reliability and decrease system size, they also achieve increased environmental sustainability, as less hardware becomes necessary for optimized system performance and less space is occupied in the manufacture and transport of the disclosed multipurpose gate driver.

In the case of automatic hardware circuit selection, a controller can implement intelligent selections by determining the optimal use case at a given moment based on monitored system inputs. The controller can implement circuit selection based on predetermined lookup tables, programmed use case priorities and/or hierarchies saved in local or remote memory, and/or based on determinations made via artificial intelligence trained using historical system data. In the case of manual circuit selection, a user can be provided with an override or a selection interface. The user can directly select the circuit selection or can select a use case that is subsequently converted to a circuit selection. It will be readily appreciated that manual and automatic selection may be implemented together in a single device or system. For example, automatic circuit selection may be carried out based on settings manually configured by a user, or a manual override can be provided that takes precedence over an automatically determined circuit selection.

In an embodiment, a hierarchal priority is provided for system design priorities or use cases, thereby allowing, for example, a default turn-off circuit to be selected unless overridden manually or by automatic control based on monitored system inputs. The system inputs can include settings preconfigured in software, firmware, or hardware. The system inputs can also include external commands generated by a user, which may be transmitted via fiber optic cables, coaxial cables, wirelessly, or by other known data transmission means. The system inputs can also include external commands generated automatically by another device within the system. The system inputs can include real-time sensing (RTS) signals or flags that are generated locally in response to monitored system conditions. The system inputs can also include inputs received from a human machine interface (HMI).

In an embodiment, an intelligent controller is provided for partially or fully automated gate drive circuit selection. The intelligent controller can include at least one programmable logic controller (PLC), field programmable gate array (FPGA), application specific integrated circuits (ASIC), and/or other like controller. Preferably, the intelligent controller prioritizes computing speed to ensure gate drive selections can be determined and implemented quickly to meet time-sensitive optimization requirements.

In an embodiment, each gate drive circuit can include any combination of active and/or passive components that facilitate optimized performance of one design priority or use case of the gate drive circuit. Switching between gate drive circuits can be accomplished by at least one multiplexer, solid state relay (SSR) integrated circuit, optocoupler, and/or other such similar known device that provides for selective switching. Switching can also be implemented directly via a controller. Hardware and/or software redundancies can also be implemented by utilizing a combination of hardware and software input detectors and switch circuit-selecting components.

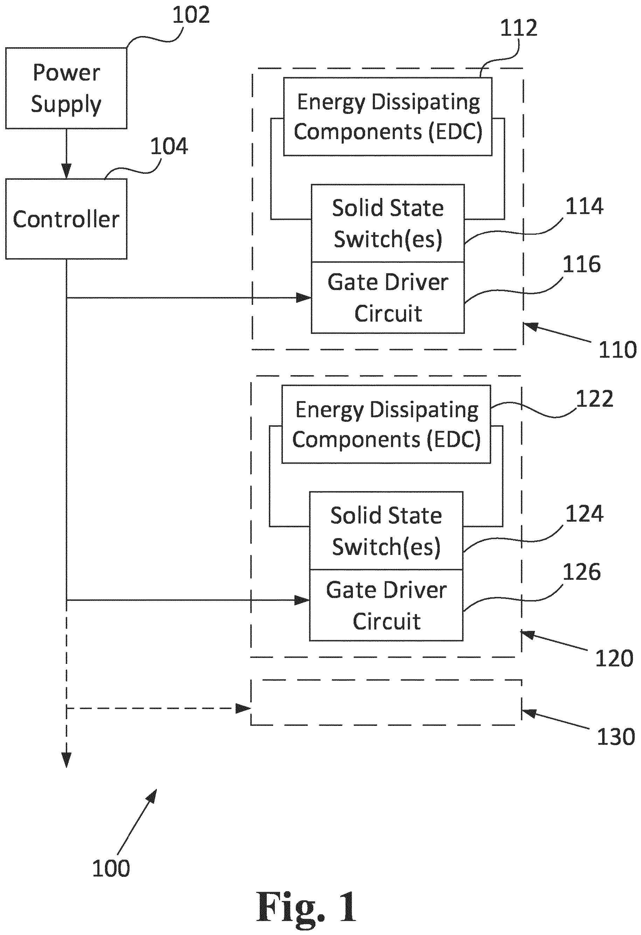

FIG. 1 illustrates a system diagram for a conventional circuit breaker system 100 having multiple design priorities and multiple corresponding gate drivers 116, 126. The conventional circuit breaker system 100 includes a power supply 102 configured to provide a supply voltage to a controller 104, which in turn is configured to provide a control voltage to a plurality of gate driver circuits 116, 126. The gate driver circuits 116, 126 are part of physically distinct hardware modules 110, 120. Each distinct hardware module 110, 120 also includes energy dissipating components (EDC) 112, 122 and one or more solid state switches 114, 124. Although FIG. 1 illustrates in some detail the components of two distinct hardware modules 110, 120, it will be readily appreciated that any number of additional hardware modules 130 may also be included in the system and controlled by the controller 104. Moreover, although FIG. 1 illustrates an exemplary embodiment in which gate driver circuits 116, 126 are implemented to control solid state switches 114, 124, it will be readily appreciated that the present disclosure is equally applicable to any system involving multiple gate driver circuits. In some instances, conventional circuit breaker systems 100 may even require two or more gate driver circuits for controlling a single hardware module, which further increases the number of gate driver circuits required in a system that includes multiple hardware modules.

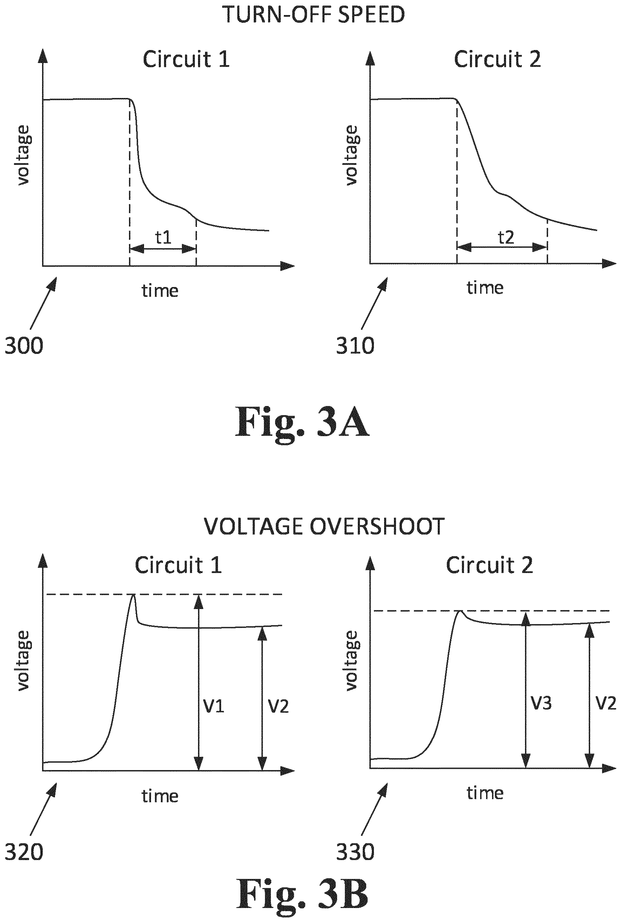

The system 100 includes distinct hardware modules 110, 120 because each module includes a respective gate driver circuit 116, 126 optimized for a particular design priority. For example, if the system 100 requires a gate driver circuit optimized for fast switching speeds in some circumstances and requires in other circumstances a gate driver circuit optimized for minimal voltage overshoot, two distinct gate driver circuits optimized for each particular design priority become necessary. Because gate driver circuits are optimized for one design priority at the expense of other design priorities (as will be illustrated and described with reference to FIGS. 3A-3C), separate gate drivers embodied in the distinct modules 110, 120 are required. The hardware modules 110, 120 may comprise, for example, commercially available gate driver integrated circuits (ICs) that are pre-optimized for a particular design priority. However, as illustrated in FIG. 1, as the number of design priorities necessitated within a system increases, the hardware footprint of system 100 increases significantly, as does the cost for each additional hardware module 130 with its own preconfigured gate driver circuit. The complexity of the system 100 in terms of its hardware requirements is thus substantial, and the necessary programming for the controller 104 to manage gate driver switching is increased. Accordingly, there is a need to mitigate the foregoing disadvantages in systems requiring more than one gate driver to address varying design priorities.

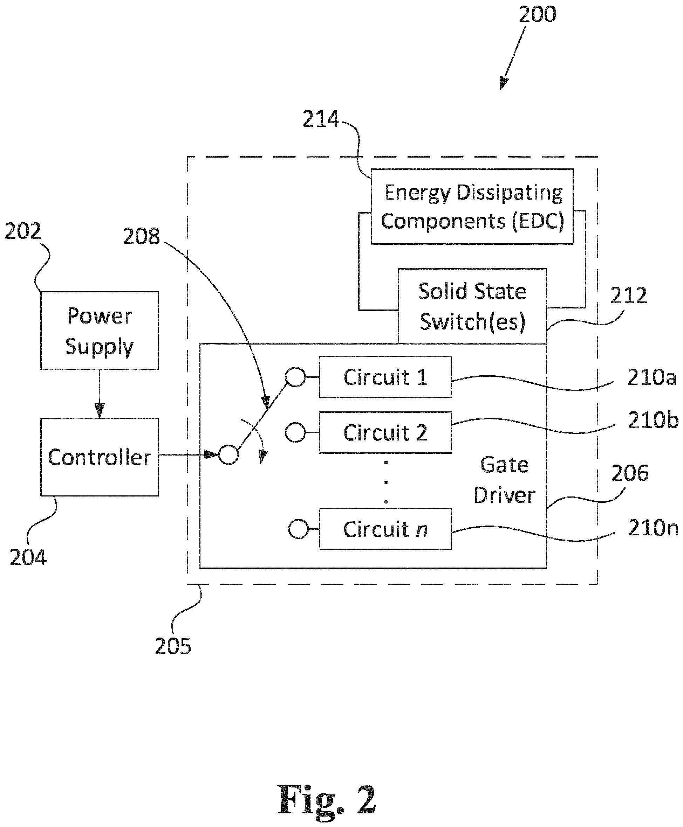

FIG. 2 illustrates a system diagram for a circuit breaker system 200 according to an embodiment of the present disclosure with a unitary multipurpose gate driver 206 (referred to hereinafter simply as a gate driver). The circuit breaker system 200 includes a power supply 202 configured to provide a supply voltage to a controller 204, which in turn is configured to provide a control voltage to a hardware module 205. The hardware module 205 includes the gate driver 206, which in turn includes a switch 208 and a plurality of gate drive circuits 210a, 210b, 210n. It will be readily appreciated that the gate driver 206 can include any number of distinct gate drive circuits 210a, 210b, 210n without departing from spirit of the present disclosure.

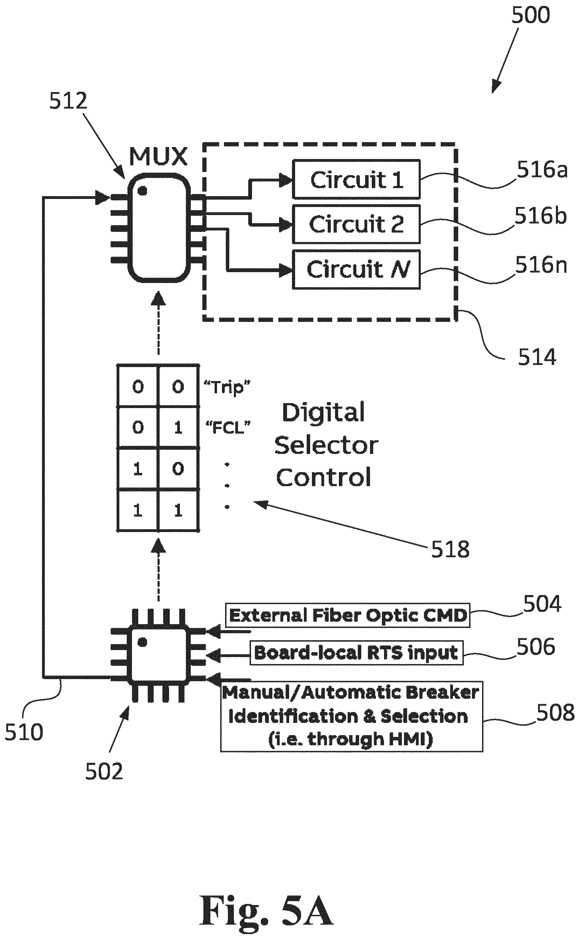

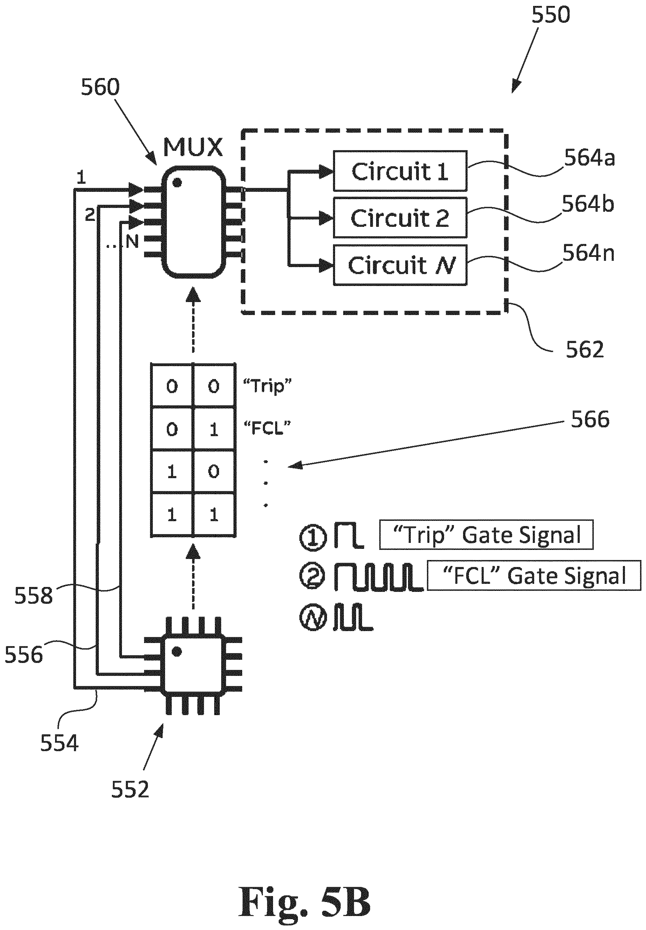

The controller 204 is configured to provide the control voltage to the gate driver 206 via the switch 208, which can be used to selectively provide the control voltage to any individual gate drive circuit 210a, 210b, 210n of the gate driver 206. Although a conventional switching apparatus is illustrated symbolically as the switch 208 in FIG. 2, it will be readily appreciated that any component or collection of components for selective coupling of a control voltage to any individual gate drive circuit 210a, 210b, 210n can be implemented without departing from the spirit of the present disclosure. For example, as illustrated and described hereafter with reference to FIGS. 5A and 5B, a multiplexer may be used for selection of individual gate drive circuits 210a, 210b, 210n of the gate driver 206. In some embodiments, switching can be carried out with one or more relays, field-effect transistors (FETs), bipolar junction transistors (BJTs), optocouplers, and/or other such known components.

The gate drive circuits 210a, 210b, 210n of the gate driver 206 are each optimized for a particular design priority of the system 200 in a manner similar to the larger gate drivers 116, 126 illustrated in FIG. 1 and described above. As a result, the gate driver 206 can switch easily between different gate drive circuits 210a, 210b, 210n to meet different design priorities of the system 200 without requiring redundant gate driver hardware (e.g., the redundant components of hardware modules 110, 120 as illustrated in FIG. 1), with a significantly reduced spatial footprint, and with reduced system complexity. The gate driver 206 is unlike conventional commercially available gate drivers, which include only one gate drive circuit optimized for one design priority (e.g., the gate drivers of FIG. 1). Unlike conventional gate drivers, the gate driver 206 can be configured to switch between any number of gate drive circuits for any number of individual design priorities.

FIG. 2 further illustrates that the hardware module includes a solid state switch 212 controlled by the gate driver 206 and corresponding energy dissipating components 214. It will be readily appreciated that the hardware module can exclude the solid state switch 212 and/or energy dissipating components 214 or be implemented instead together with different components without departing from the spirit of the present disclosure.

FIGS. 3A-3B illustrate variations in turn-off speed, voltage overshoot, and device current, respectively, of two gate drive circuits. The first gate drive circuit (Circuit 1) of each of FIGS. 3A-3C are the same circuit, and second gate drive circuit (Circuit 2) of FIGS. 3A-3C are the same circuit. The varying measurements illustrated in FIGS. 3A-3C are illustrated for both the first and second gate drive circuits for comparative purposes and to illustrate how varying gate drive circuits can be optimized for one design priority (e.g., minimized turn-off speed or voltage overshoot) of a system at the expense of other design priorities.

FIG. 3A illustrates variations in turn-off speed of the first and second gate drive circuits. In particular, a first graph 300 for the first gate drive circuit and a second graph 310 for the second gate drive circuit are illustrated. The graphs 300, 310 plot output voltages of a gate drive circuit measured over time, the voltages being measured at the gate and source of a MOSFET (or at the gate and emitter, in the case of an IGBT) of a solid state switch connected to the gate drive circuit. As illustrated in FIG. 3A, the varying circuits have varying performance with respect to turn-off speed. The first gate drive circuit is optimized for turn-off speed, and therefore achieves a turn-off time t1 that is shorter than the turn-off time t2 achieved by the second gate drive circuit. Thus, the first gate drive circuit is optimized for the design priority of turn-off speed while the second gate drive circuit is not.

FIG. 3B illustrates variations in voltage overshoot of the solid-state switch connected to the first and second gate drive circuits of FIG. 3A. The graphs 320, 330 plot voltages measured over time across the drain and source of a MOSFET (or across the collector and emitter, in the case of an IGBT) of the solid state switch. As illustrated in FIG. 3B, the varying circuits have varying performance with respect to voltage overshoot. In particular, the second gate drive circuit is optimized for minimal voltage overshoot, and thus has a smaller voltage overshoot (V3-V2) compared to the voltage overshoot of the first gate drive circuit (V1-V2). Thus, the second gate drive circuit is optimized for the design priority of voltage overshoot while the first gate drive circuit is not.

FIGS. 3A and 3B illustrate how different design priorities in a system must be addressed by different gate drive circuitry. The first gate drive circuit (Circuit 1) is optimized for turn-off speed at the expense of voltage overshoot performance, and the second gate drive circuit (Circuit 2) is optimized for voltage overshoot at the expense of turn-off speed performance. Thus, in a system that requires both design priorities (e.g., minimal turn-off speed in some instances and minimized voltage overshoot in other instances), both gate drive circuits (Circuits 1 and 2) would have to be implemented in the system for fully optimized system performance. However, as conventional gate drivers include only a gate drive circuit with one design priority or use case in mind, conventional systems require multiple gate driver ICs. In contrast, embodiments of the present disclosure can advantageously provide both gate drive circuits (Circuits 1 and 2) or any number of gate drive circuits in a single IC, a single board, or a single hardware module.

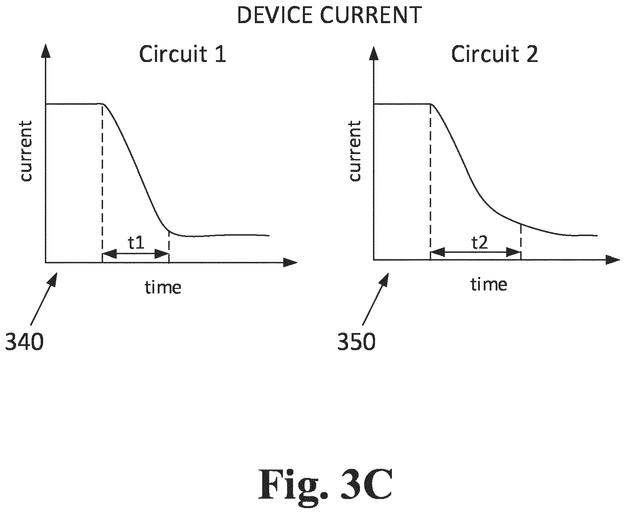

FIG. 3C illustrates variations in device current of the first and second gate drive circuits in graphs 340, 350. Device current is plotted over time in each graph 340, 350. The current levels in graphs 340, 350 are generally the same, but the different circuits have varying performance with respect to how quickly current level changes are achieved. The first gate drive circuit is optimized for turn-off speed, and therefore achieves a turn-off time t1 that is shorter than the turn-off time t2 achieved by the second gate drive circuit.

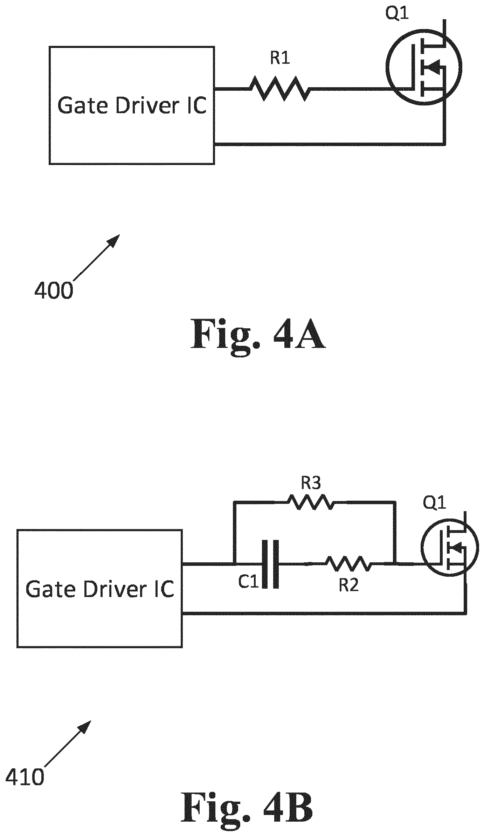

FIGS. 4A and 4B illustrate circuit diagrams of different gate drive circuits. The gate drive circuits of FIGS. 4A and 4B are understood to be simplified and illustrative of how gate drive circuits may vary, but are not understood to limit the scope of gate drive circuits within the present disclosure as including only the particular components illustrated therein.

FIG. 4A illustrates a first gate drive circuit 400 having a gate driver integrate circuit (IC) connected to a resistor R1 and a semiconductor device Q1 (e.g., an IGBT, MOSFET, or IGCT). The first gate drive circuit 400 can be, for example, a general configuration of the second gate drive circuit (Circuit 1) of FIGS. 3A-3C.

FIG. 4B illustrates a second gate drive circuit 410 having a gate driver IC connected to a capacitor C1, resistors R2, R3, and a semiconductor device Q1. The capacitor C1 and resistor R2 are connected in series, and are collectively arranged in parallel with resistor R3. It

It will be readily appreciated that varying gate drive circuits can be provided in embodiments of the present disclosure, each gate drive circuit having varying arrangements of components (for example, as illustrated by the component variation between FIGS. 4A and 4B) and/or varying properties of components (e.g., different resistances for resistors R1, R2, R3 and/or different capacitances of capacitors C1). For example, a system according to an embodiment of the present disclosure can include a plurality of gate drive circuits that each have the configuration of FIG. 4A, but each having a resistor with a different resistance. This would allow for selection between the different resistance values as needed. Likewise, a system can include both the gate drive circuits 400, 410 of FIGS. 4A and 4B, and/or a plurality of gate drive circuits according to FIG. 4B with varying capacitances and/or resistances.

Because each of the gate drive circuits 400, 410 of FIGS. 4A and 4B have varying components and/or electrical properties, each have different design priorities relative to one another and may be utilized within a single gate driver according to embodiments of the present disclosure so that each may be utilized at an optimal time according to a system's needs. It will be readily appreciated that FIGS. 4A and 4B are illustrative only in that any number of varying gate drive circuits may be implemented in a single multipurpose gate driver according to the present disclosure, thereby providing for optimized performance across any number of scenarios and design priorities.

FIGS. 5A and 5B schematically illustrate multipurpose gate driver systems according to embodiments of the present disclosure. In particular, FIG. 5A illustrates a first system 500 having a controller 502 configured via internally stored logic (e.g., firmware) to provide a control signal 510 to a multiplexer 512 based on inputs 504, 506, 508, the multiplexer 512 being electrically connected to a gate driver module 514. The gate driver module 514 includes any number of gate drive circuits 516a, 516b, 516n, each of which are connected separately to the multiplexer 512. The controller 502 is configured to receive a plurality of inputs 504, 506, 508 from varying system components in order to determine, based on these inputs, which gate drive circuit 516a, 516b, 516n should be selected. Based on this determination, the controller 502 carries out digital selector control 518 by outputting digital signals to the multiplexer 512 that indicate which output of the multiplexer 512 the control signal 510 should be connected to. The controller 502 can thereby control the appropriate gate drive circuit 516a, 516b, 516n for a particular use case based on the inputs 504, 506, 508. It will be readily appreciated that the multiplexer 512 is illustrative only and can include any number of outputs in a 1:N configuration. The inputs 504, 506, 508 can include, for example, external fiber optic chromo-modal dispersion (CMD), board-local RTS input, and/or manual or automatic breaker identification and selection which may be received via, for example, an HMI. The inputs 504, 506, 508 can also include sensor data measured from any number of sensors configured to measure environmental or internal performance parameters or conditions. The inputs 504, 506, 508 can be monitored by the controller 502 constantly, so that gate drive circuit switching can be accomplished in real-time in a continuous and intelligent manner. The controller 502 can be pre-programmed with configuration settings that define use case requirements of a system for a particular application. Alternatively, or in addition, the controller 502 can receive configuration settings indicative of system use case requirements from a user interface based on inputs from a user, or can determine configuration settings on a periodic or as-needed basis. In comparison to the embodiment of FIG. 5B, which will be described in greater detail below, the embodiment of FIG. 5A is comparatively more capable of intelligent control, as the controller 502 can determine and output one of a variety of waveforms automatically using received inputs and system parameters and/or information.

FIG. 5B illustrates a second system 550 having a controller 552 configured to provide a plurality of control signals 554, 556, 558 to a multiplexer 560, the multiplexer 560 being electrically connected to a gate driver module 562. The controller 552 is configured to output different signals 554, 556, 558 to the multiplexer 560, but only one of these signals 554, 556, 558 is connected to an output of the multiplexer 560 based on digital selector control 566 carried out by the controller 552. It will be readily appreciated that the multiplexer 560 is illustrative only and can include any number of inputs in an N:1 configuration. In contrast to the embodiment of FIG. 5A, the multiplexer 560 outputs the same signal to a plurality of gate drive signals 564a, 564b, 564n, but passes only one of the plurality of control signals 554, 556, 558 as an output. The signals 554, 556, 558 output by the controller 552 can include varying predetermined digital and/or analog signals. For example, the signals 554, 556, 558 can include square or sinusoidal waves of varying frequency or pulse width modulation (PWM) signals with predetermined correspondence to a switch state selection. The switch states can include, for example, a "trip" gate signal, a "fault-current limiting (FCL)" gate signal, and/or any other number of signals corresponding to design priorities optimized by the gate drive circuits 564a, 564b, 564n implemented in the system 550. Selective switching of the connection between the multiplexer 560 output and individual gate drive circuits 564a, 564b, 564n is carried out by other external components, which can include, for example, one or more FCL circuits that determine a switching pattern (e.g., the FCL gate signal of FIG. 5B) and/or one or more fault detection circuits that determine a switching pattern (e.g., the Trip gate signal of FIG. 5B). The embodiment of FIG. 5B is generally more suitable for manual control or input settings of the controller 552, as the controller need only pick between predetermined gate drive signals. The determination of which of the predetermined gate drive signals should be selected may even be externally provided (e.g., provided by an external component to the controller 552).

It will be readily appreciated that different switching components other than a multiplexer may be implemented without departing from the spirit of the present disclosure or even of the illustrative embodiment of FIGS. 5A and 5B. For example, switching can be carried out with one or more relays, field-effect transistors (FETs), bipolar junction transistors (BJTs), optocouplers, and/or other such known components and still provide previously described advantages of the present disclosure, such as space and cost savings and reduced system complexity. Regardless of the particular form of the switching component, the switching component can provide isolation between a controller and a component (e.g., a solid-state switch) at the gate of a semiconductor device (e.g., (IGBT, IGCT, or MOSFET).

It will be readily understood that still other embodiments can be provided which combine the features of the embodiments of FIGS. 5A and 5B. For example, a multiplexer (or more generally a switching component) can be provided with an N:N configuration, where a number of distinct waveforms from a controller can be selected from, and a number of outputs for unique control of a plurality of gate drive circuits can be provided.

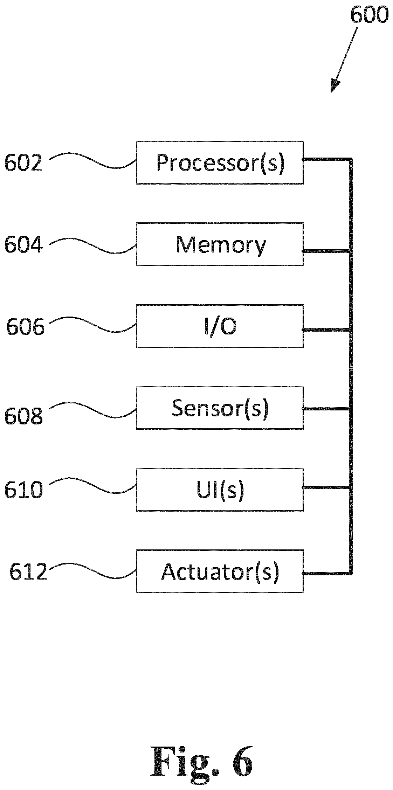

Referring to FIG. 6, a processing system 600 can include one or more processors 602, memory 604, one or more input/output devices 606, one or more sensors 608, one or more user interfaces 610, and one or more actuators 612. Processing system 600 can be representative of each computing system disclosed herein, including the controllers 502, 552 of FIGS. 5A and 5B, for example.

Processors 602 can include one or more distinct processors, each having one or more cores. Each of the distinct processors can have the same or different structure. Processors 602 can include one or more central processing units (CPUs), one or more graphics processing units (GPUs), circuitry (e.g., ASICs), digital signal processors (DSPs), and the like. Processors 602 can be mounted to a common substrate or to multiple different substrates.

Processors 602 are configured to perform a certain function, method, or operation (e.g., are configured to provide for performance of a function, method, or operation) at least when one of the one or more of the distinct processors is capable of performing operations embodying the function, method, or operation. Processors 602 can perform operations embodying the function, method, or operation by, for example, executing code (e.g., interpreting scripts) stored on memory 604 and/or trafficking data through one or more ASICs. Processors 602, and thus processing system 600, can be configured to perform, automatically, any and all functions, methods, and operations disclosed herein. Therefore, processing system 600 can be configured to implement any of (e.g., all of) the protocols, devices, mechanisms, systems, and methods described herein.

For example, when the present disclosure states that a method or device performs task "X" (or that task "X" is performed), such a statement should be understood to disclose that processing system 600 can be configured to perform task "X". Processing system 600 is configured to perform a function, method, or operation at least when processors 602 are configured to do the same.

Memory 604 can include volatile memory, non-volatile memory, and any other medium capable of storing data. Each of the volatile memory, non-volatile memory, and any other type of memory can include multiple different memory devices, located at multiple distinct locations and each having a different structure. Memory 604 can include remotely hosted (e.g., cloud) storage.

Examples of memory 604 include a non-transitory computer-readable media such as RAM, ROM, flash memory, EEPROM, any kind of optical storage disk such as a DVD, a Blu-Ray^{®} disc, magnetic storage, holographic storage, a HDD, a SSD, any medium that can be used to store program code in the form of instructions or data structures, and the like. Any and all of the methods, functions, and operations described herein can be fully embodied in the form of tangible and/or non-transitory machine-readable code (e.g., interpretable scripts) saved in memory 604.

Input-output devices 606 can include any component for trafficking data such as ports, antennas (i.e., transceivers), printed conductive paths, and the like. Input-output devices 606 can enable wired communication via USB^{®}, DisplayPort^{®}, HDMI^{®}, Ethernet, and the like. Input-output devices 606 can enable electronic, optical, magnetic, and holographic, communication with suitable memory 606. Input-output devices 606 can enable wireless communication via WiFi^{®}, Bluetooth^{®}, cellular (e.g., LTE^{®}, CDMA^{®}, GSM^{®}, WiMax^{®}, NFC^{®}), GPS, and the like. Input-output devices 606 can include wired and/or wireless communication pathways.

Sensors 608 can capture physical measurements of an environment and/or parameters of an electrical system and report the same to processors 602. For example, the sensors 608 can measure voltage and/or current at one or more points within a system. User interface 610 can include displays, physical buttons, speakers, microphones, keyboards, and the like. Actuators 612 can enable processors 602 to control mechanical forces. For example, actuators 612 can include relays or switches controlled by the processors 602 to implement a gate drive circuit selection.

Processing system 600 can be distributed. For example, some components of processing system 600 can reside in a remote hosted network service (e.g., a cloud computing environment) while other components of processing system 600 can reside in a local computing system. Processing system 600 can have a modular design where certain modules include a plurality of the features/functions shown in FIG. 6. For example, I/O modules can include volatile memory and one or more processors. As another example, individual processor modules can include read-only-memory and/or local caches.

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A multipurpose gate driver (206), comprising:
an input for receiving an input signal;
a plurality of gate drive circuits (210a...210n) each configured with a different combination of passive and/or active electrical components; and
at least one switch (208) arranged between the input and each of the plurality of gate drive circuits, the at least one switch configured to switch between each of the plurality of gate drive circuits and thereby divert a drive signal to any one of the plurality of gate drive circuits,
wherein the switch is configured to switch between the plurality of gate drive circuits based on the input signal received from the input.

2. The multipurpose gate driver of claim 1, wherein the plurality of gate drive circuits includes at least one voltage overshoot minimization circuit and at least one turn-off switching time minimization circuit.

3. The multipurpose gate driver of claim 1 or 2, wherein the plurality of gate drive circuits are arranged on a single board.

4. The multipurpose gate driver of any one of the previous claims, wherein the gate drive circuits are configured to modify and transmit the drive signal to a semiconductor device, wherein the semiconductor device is on of an insulated-gate bipolar transistor, IGBT, a metal-oxide-semiconductor field-effect transistor, MOSFET, or an integrated gate-commutated thyristor, IGCT.

5. The multipurpose gate driver of claim 4, further comprising a controller (204) configured to output the drive signal to the input of the semiconductor device,
wherein the controller receives a plurality of external input signals, and
wherein the controller outputs the drive signal to the input of the semiconductor device based on the plurality of external input signals.

6. The multipurpose gate driver of any one of the previous claims, wherein the switch includes a multiplexer.

7. The multipurpose gate driver of any one of claims 1 to 5, wherein the switch includes at least one relay, field-effect transistors, FET, bipolar junction transistor, BJT and/or optocoupler.

8. A multipurpose power electronic switch system (500, 520), comprising:
a multipurpose gate driver (514, 562) including:
an input for receiving at least one input signal,
a plurality of gate drive circuits (516a, 516b, 516c; 564a, 564b, 564n) each configured with a different combination of passive and/or active electrical components, and
at least one switch (512, 560) arranged between the input and each of the plurality of gate drive circuits, at least one switch configured to switch between each of the plurality of gate drive circuits and thereby divert a drive signal to any one of the plurality of gate drive circuits,
wherein the switch is configured to switch between the plurality of gate drive circuits based on the at least one input signal received from the input; and
at least one input device configured to output the at least one input signal.

9. The system of claim 8, wherein the at least one input device includes a controller configured to output a single signal as the at least one input signal to the at least one input of the multipurpose gate driver.

10. The system of claim 9, wherein the controller is further configured to output digital selector signals to the at least one switch of the multipurpose gate driver.

11. The system of any one of claims 8 to 10, wherein the at least one input device includes a plurality of devices each configured to independently output an input signal to the at least one input of the multipurpose gate driver.

12. The system of any one of claims 8 to 11, wherein the multipurpose gate driver further includes an output and wherein the multipurpose power electronic switch system further comprises a circuit breaker electrically connected to the output of the multipurpose gate driver.

13. The system of claim 12, wherein the circuit breaker is a solid-state circuit breaker.

14. The system of any one of claims 8 to 13, wherein each of the plurality of gate drive circuits is optimized for different performance priorities, the performance priorities including at least a minimal turn-off speed and a minimal voltage overshoot.

15. A method for providing a signal to an insulated-gate bipolar transistor, IGBT,, a metal-oxide-semiconductor field-effect transistor, MOSFET, or integrated gate-commutated thyristor, IGCT, the method comprising:
receiving a control signal and a selector signal;
transmitting the control signal to one of a plurality of gate drive circuits via a switch, a position of the switch being based on the selector signal;
modifying the control signal via the one gate drive circuit of the plurality of gate drive circuits to which the control signal is transmitted; and
outputting, via the one gate drive circuit to which the control signal is transmitted, the modified control signal to the IGBT, MOSFET, or IGCT.

16. The method of claim 15, wherein the IGBT, MOSFET, or IGCT are connected with a solid-state switch, and wherein the modified control signal output by the one gate drive circuit is configured to control a state of the solid-state switch.
